# EUROPEAN PATENT APPLICATION

(11) **EP 2 211 367 A1**
(43) Date of publication of application: **28.07.2010**
(21) Application number: 09151036.2
(22) Date of filing: 21.01.2009
(51) Int. Cl.: H01J 37/09

(54) **Particle beam device with reduced emission of undesired material**

(71) Applicant: Applied Materials, Inc., Santa Clara, CA 95054 (US)
(72) Inventor: Krempel-Hesse, Joerg, 63683 Eckartsborn (DE)
(74) Representative: Zimmermann & Partner

(57) **Abstract**

A particle beam impurity removing device for removing impurities from a particle beam emitted in a beam direction is provided, including an emission angle confinement means (118; 1182) adapted to confine emission angles of particles included in the particle beam.

## Description

### FIELD OF THE INVENTION

Embodiments of the invention generally relate to particle beam devices, for instance charged particle beam devices, with reduced emission of undesired material. More particularly, they relate to a particle beam impurity removing device, a particle beam device, a substrate processing installation, and a method of manufacturing a particle beam impurity removing device. Specifically, they relate to a particle beam impurity removing device for removing impurities from a particle beam directed to a substrate surface, a particle beam device including a particle beam impurity removing device, a substrate processing installation including a particle beam device, and a method of manufacturing a particle beam impurity removing device.

### BACKGROUND OF THE INVENTION

Typical particle beam devices are electron sources or ion sources. One example of an ion source is a plasma ion source, such as a Penning type plasma ion source or a Multicusp plasma ion source. Typically, the plasma ion source is held under vacuum and produces ions using a plasma generated within a plasma chamber, e.g. by dc (decent current) discharge or rf (radiofrequency) induction discharge.

In a typical ion source, thermal electrons are emitted from a cathode, accelerated under the influence of an electric field and may be constrained by a magnetic field. The desired plasma is produced by interactions of the thermal electrons with gas molecules contained in the plasma chamber. Typically, plasma ions are extracted from the plasma chamber via an aperture provided in a front plate. An extraction electrode assembly may be provided adjacent to the aperture to extract ions from the ion source.

Particle beam devices, such as charged particle beam devices, may be used in the manufacture of displays, such as LCD, TFT displays and OLED (Organic Light Emitting Diode), in solar wafer manufacturing and in semiconductor device production. For instance, ion sources may be used in processes for cleaning or pre-treating substrates or implanting ions into substrates. However, known particle beam devices used in manufacturing processes may generate particle beams including undesired material, for instance due to sputtering events inside of the particle beam devices, thereby reducing the performance of the manufactured products.

### SUMMARY

In light of the above, a particle beam impurity removing device according to claim 1, a particle beam device according to claim 3, a substrate processing installation according to claim 14 and a method according to claim 16 are provided.

According to one embodiment, a particle beam impurity removing device for removing impurities from a particle beam emitted in a beam direction is provided, including an emission angle confinement means adapted to confine emission angles of particles included in the particle beam.

According to another embodiment, a particle beam device is provided, including a housing, a particle beam source included in the housing, an opening in the housing for emission of a particle beam from the housing in a beam direction, and a particle beam impurity removing device including an emission angle confinement means adapted to confine emission angles of particles included in the particle beam and being provided adjacent to the opening.

According to a further embodiment, a substrate processing installation is provided, including a particle beam device, the particle beam device including a housing, a particle beam source included in the housing, an opening in the housing for emission of a particle beam from the housing in a beam direction, and a particle beam impurity removing device including an emission angle confinement means adapted to confine emission angles of particles included in the particle beam and being provided adjacent to the opening.

According to a further embodiment, a method of manufacturing a particle beam impurity removing device is provided, including a step of including into the particle beam impurity removing device at least one element selected from the group consisting of an emission angle confinement means adapted to confine the emission angles of a particle beam, an emission angle confinement means adapted to be provided within the particle beam and an emission angle confinement means adapted to be provided throughout a cross section of the particle beam.

Further features and details are evident from the dependent claims, the description and the drawings.

Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, software, a computer programmed by appropriate software, by any combination thereof or in any other manner.

### BRIEF DESCRIPTION OF THE DRAWINGS

So that the manner in which the above recited features of embodiments can be understood in detail, a more particular description of embodiments of the invention, briefly summarized above, may be had by reference to examples of embodiments. The accompanying drawings relate to embodiments of the invention and are described in the following. Some of the above mentioned embodiments will be described in more detail in the following description of typical embodiments with reference to the following drawings in which:

Fig. 1 shows schematically a particle beam device according to embodiments described herein;

Fig. 2 illustrates schematically a front view of the particle beam device shown in Fig. 1;

Fig. 3 shows schematically a perspective side view of the particle beam device shown in Fig. 1;

Fig. 4 shows schematically a further particle beam device according to embodiments described herein;

Fig. 5 shows schematically a particle beam device according to embodiments described herein;

Fig. 6 shows schematically a further particle beam device according to embodiments described herein;

Fig. 7 shows schematically another particle beam device according to embodiments described herein;

Fig. 8 illustrates schematically another particle beam device according to embodiments described herein;

Fig. 9 illustrates schematically a part of a particle beam impurity removing device according to embodiments described herein; and

Fig. 10 shows schematically a part of another particle beam impurity removing device according to embodiments described herein.

It is contemplated that elements of one embodiment may be advantageously utilized in other embodiments without further recitation.

### DETAILED DESCRIPTION OF THE DRAWINGS

Reference will now be made in detail to the various embodiments, one ore more examples of which are illustrated in the figures. Each example is provided by way of explanation, and is not meant as a limitation of the invention.

Without limiting the scope, in the following the examples and embodiments of the particle beam impurity removing device, the particle beam device, the substrate processing installation, and the method of manufacturing a particle beam impurity removing device are described referring to ion sources for processing of substrates, e.g. pre-treatment or cleaning, in particular ion etching of substrates. In some examples, the particle beam impurity removing device and the particle beam device of embodiments described herein include vacuum-compatible materials and are provided in a substrate processing vacuum chamber. Applications of embodiments of devices described herein are for example in the production of displays, such as LCD, TFT displays and OLED (Organic Light Emitting Diode), in solar wafer manufacturing and in semiconductor device production.

A typical application of the particle beam impurity removing device and the particle beam device of embodiments described herein may be in vacuum compartments of substrate processing installations, such as coating installations. The particle beam impurity removing device and the particle beam device particularly may be utilized for pre-treatment processes in installations for coating substrates with thin films. Moreover, embodiments described herein may be used for any application of a particle source, which requires parallel incidence of evaporated or sputtered material, while the particle source delivers a wide emission characteristic, e.g. in the production of tips for field effect displays.

Without limiting the scope, the substrates to be processed using embodiments disclosed herein may be glass substrates, e.g. rectangular plate-shaped glass substrates. Furthermore, other substrates, such as a web or plastic films, having modified shapes may be employed. Moreover, the substrate(s) may be delivered to the processing chamber continuously or may be provided in the processing chamber in a discontinuous mode. In addition, the processing chamber is not limited to a vacuum chamber.

The term "particle" as used herein may, without limiting the scope, include at least one element selected from the group consisting of evaporated particles, sputtered particles, positively charged particles, negatively charged particles, positive and/or negative ions, electrons, neutral atoms, charged atoms, neutral molecules and charged molecules. Moreover, the term "impurity" as used herein may generally refer to contaminations or particles other than the desired particles of the particle beam. Further the term "particle beam impurity removing device" may also be referred to herein as "impurity removing device".

According to some embodiments, the particle beam device is at least one element selected from the group consisting of a charged particle beam device, an ion source and an electron source, and the particle beam may include charged particles, ions and/or electrons. Without limiting the scope, one example of an ion source is a plasma ion source, such as a Penning type plasma ion source or a Multicusp plasma ion source. Typically, the plasma ion source is held under vacuum and produces ions using a plasma generated within a plasma chamber, e.g. by dc (decent current) discharge or rf (radiofrequency) induction discharge.

Within the following description of the drawings, the same reference numbers refer to the same components. Generally, only the differences with respect to the individual embodiments are described.

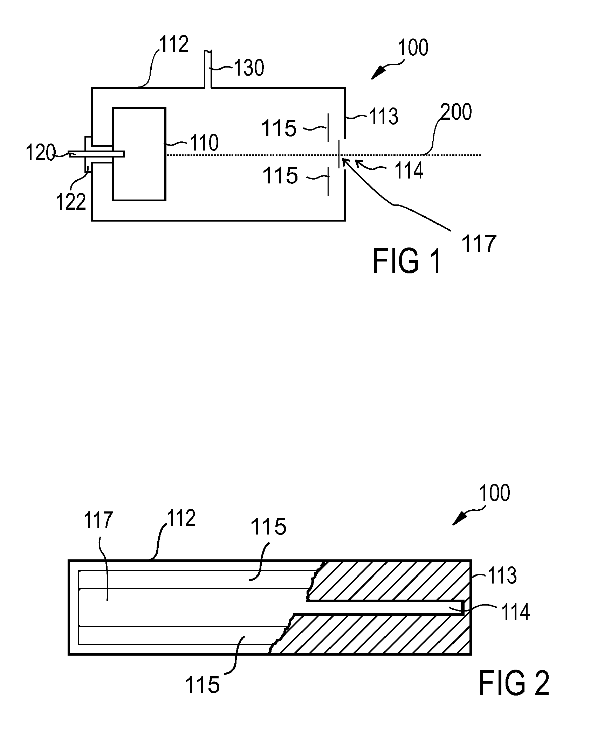

Fig. 1 shows schematically a cross-sectional view of an ion source 100, as an example of a particle beam device according to embodiments described herein. Fig. 2 illustrates a side view of the ion source 100. The ion source 100 includes a cathode 110 mounted within a housing 112 such that a separation space at the bottom, at the top and at the side is provided. A front portion 113 of the housing 112 has an opening 114, for example a slit-opening. The separation spaces, i.e. the separation spaces which do not face the front surface 113 of the ion source 100 can be formed to be substantially uniform. Typically, they are sufficiently large to prevent arcing and can for example be in a range of 2 to 12 mm, typically 3 to 8 mm, for example, 4 to 5 mm. An extraction electrode 115 is provided adjacent to the opening 114 to extract ions from the ion source 100 such that they can exit through the opening 114. According to embodiments described herein, the ion source 100 further includes a particle beam impurity removing device 117 adjacent to opening 114.

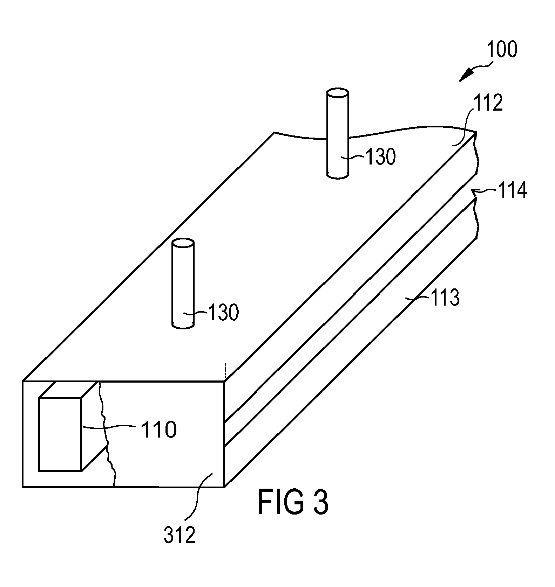

In some embodiments, which can be combined with any other embodiment described herein, and as indicated in Figs. 2 and 3, the opening 114 of the ion source 100 may be a slit opening, thereby providing a linear beam of a linear ion source. Such a linear ion source may be utilized for processing of large area substrates.

According to embodiments described herein, the ion source 100 can be mounted within a vacuum chamber. Thereby, the region exterior of the housing 112 and, in particular, the region between the opening 114 of the ion source and a substrate (not shown) for impingement of the ions can be evacuated to a pressure of, for example, 10⁻² to 10⁻⁴ mbar. The ion source 100 is connected to a gas supply (not shown) having a gas conduit 130. The flow of gas can be regulated such that the pressure within the housing corresponds to a pressure about 10⁻² to 10⁻⁴ mbar, typically above 10⁻³ mbar, more typically a pressure above 10⁻² mbar. According to different embodiments described herein, the gas which may be inserted into the housing 112 through the gas conduit 130 can be a gas at least from the group consisting of noble gases, e.g., argon, N₂, O₂, CO₂ and mixtures thereof.

According to embodiments described herein, which can be combined with other embodiments described herein, the cathode 110 is connected to a power supply by an electrical conduit or conductor 120. The electrical conductor passes through an isolating cathode support member 122. According to yet further embodiments, the isolating cathode support member 122 is also provided in a gas sealing manner such that the pressure difference from the interior of the housing 112 and the exterior of the housing 112 can be maintained. The housing 112 may be grounded.

In operation, electrons are generated by the cathode 110 and accelerated inside of the housing 112, e.g. towards an electrode (not shown) under the influence of an electric field. The desired plasma is produced by interactions of the electrons with gas molecules contained in the housing 112. Ions are extracted from the ion source 100 by extraction electrode 115 adjacent to the opening 114 such that they can exit through the opening 114 along an optical axis 200 indicating the ion beam direction.

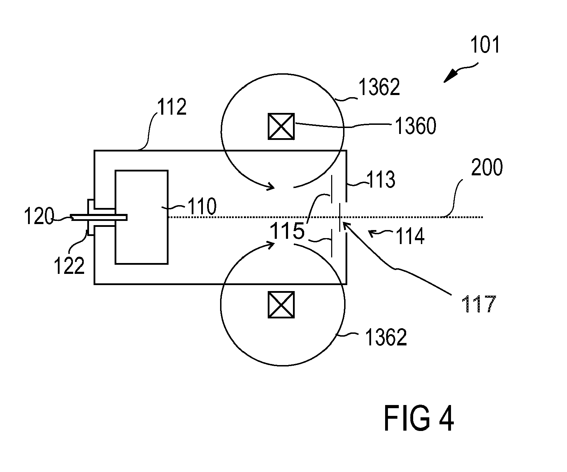

According to a yet further embodiment, which can be combined with other embodiments described herein, the plasma generated inside of the housing 112 can be constrained by a magnetic field. Fig. 4 shows as an example an ion source 101 having a coil 1360 provided around the housing 112. The coil 1360 may be provided near the front portion of the ion source 101 and provides a magnetic field as indicated by arrows 1362. Thereby, the plasma is confined inside of the housing 112.

The particles extracted by extraction electrode 115 may, however, include impurities, since the generated plasma or the accelerated ions may sputter the inside walls or other inside components of the ion sources. For instance, sputter material from the cathode of the ion sources 100, 101 may escape through the opening 114 and deposit on a substrate being processed.

In light of this, according to one embodiment, a particle beam impurity removing device for removing impurities from a particle beam emitted in a beam direction is provided, including an emission angle confinement means adapted to confine emission angles of particles included in the particle beam. In some embodiments the emission angle confinement means may include a plurality of guiding tubes and/or collimation tubes.

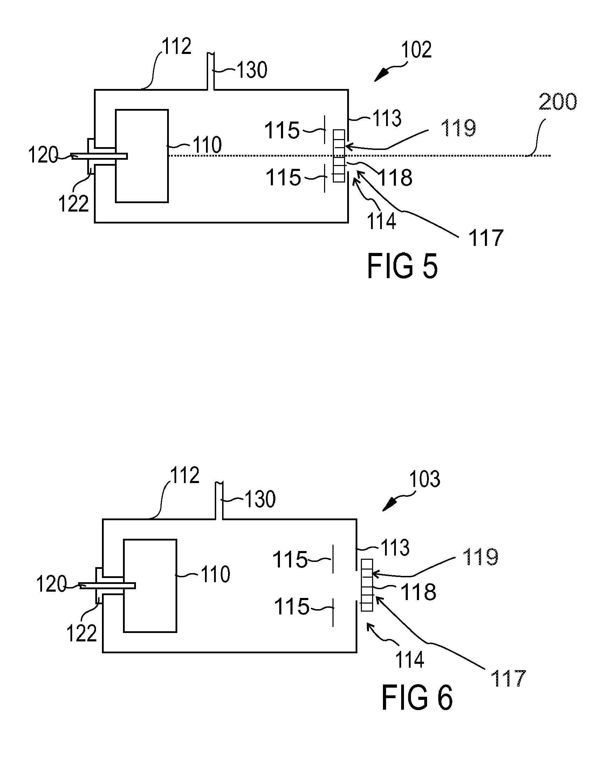

In embodiments described herein, a particle beam device is provided, including a housing, a particle beam source included in the housing, an opening in the housing for emission of a particle beam from the housing in a beam direction, and a particle beam impurity removing device including an emission angle confinement means adapted to confine emission angles of particles included in the particle beam and being provided adjacent to the opening. For instance, the particle beam impurity removing device may be provided in the embodiments of the particle beam devices shown in Figs. 1 to 4 adjacent to opening 114. As representative examples, the embodiments of Figs. 1 to 5 include a particle beam impurity removing device 117 between extraction electrodes 115 and aperture 114. As shown in Fig. 5, the particle beam impurity removing device 117 may include an emission angle confinement means 119.

The emission angle confinement means of embodiments may be adapted to remove particles having trajectories substantially non-parallel to the beam direction of the particle beam. Moreover, according to embodiments which may be combined with any other embodiment described herein, the emission angle confinement means may be adapted to be provided within the particle beam or may be provided within the particle beam, e.g. within a cross section perpendicular to the beam direction. For instance, in some embodiments, the emission angle confinement means may be adapted to be provided throughout a cross section of the particle beam or may be provided throughout a cross section of the particle beam, e.g. across an entire cross section of the particle beam.

Embodiments of the particle beam impurity removing device and of the particle beam device described herein allow for removal of impurities from a particle beam, such as particles other than the desired particles of the particle beam. For instance, impurities having trajectories substantially non-parallel to the desired beam direction of the particle beam may be removed according to embodiments. Thereby, impurities contained in the particle beam device, e.g. contaminants generated by sputtering of the cathode inside of the particle beam device, may be shielded. For example, such impurities may be deflected and/or trapped by the particle beam impurity removing device, e.g. they may be adsorbed at the surface of the particle beam impurity removing device, such that they are removed from the particle beam. Since in some cases, e.g. in case of undesired sputtering of internal components of the particle source, the impurities included in the particle beam predominantly have trajectories non-parallel to the beam direction of the particle beam, a substantial fraction, e.g. up to about 99 %, of the impurities contained in the particle beam may be removed using embodiments described herein. In addition, particles, which are desired to be included in the particle beam, may be aligned with the beam direction by the particle beam impurity removing device of embodiments described herein.

According to some embodiments, which can be combined with any other embodiment described herein, the emission angle confinement means may include a plurality of three dimensional apertures having a length in a direction parallel to an emission angle of particles included in the particle beam. For instance, in some embodiments, the emission angle confinement means may include a plurality of three dimensional apertures having a length in a direction parallel to the beam direction of the particle beam. Hence, the emission angle confinement means has a large surface for adsorption and/or deflection of impurities contained in the particle beam.

For example, the particle beam impurity removing device 117 illustrated in Fig. 5 includes an emission angle confinement means 118 having in one embodiment a plurality of apertures 119. According to the present example, the apertures 119 are tubular and have a length in parallel to the beam direction 200, which is in the present example perpendicular to the front portion 113. However, in other embodiments of the particle beam device having a modified beam direction arranged non-perpendicular to the front portion 113, the length of the apertures 119 may be oriented in parallel to the modified beam direction.

In further embodiments, each of the plurality of three dimensional apertures may have a width, e.g. in case of a circular cross section of the apertures a diameter or in case of a polygonal cross section of the apertures they may have an averaged width. The widths of the three dimensional apertures may be perpendicular to their lengths. The length to width ratio of the apertures may be in a range of 1 to 5, typically 2 to 4.5, more typically 2.5 to 4. In one embodiment, the length of each three dimensional aperture may be in a range of typically about 9 to 13 mm, more typically about 10 to 12 mm. Moreover, the width may be in a range of typically about 2 to 5 mm, more typically about 3 to 4 mm. The length-width-relation of the three-dimensional apertures can be used to adjust the emission angle of the ion source for all particles passing through the emission angle confinement means of embodiments described herein.

In other embodiments, which can be combined with any other embodiment described herein, the emission angle confinement means includes at least one element selected from the group consisting of tubular apertures, tubular apertures having a circular cross section, tubular apertures having a polygonal cross section, apertures arranged in a pattern, apertures arranged in a regular pattern, and a honeycomb structure.

According to some embodiments, the emission angle confinement means is formed of a material including at least one element selected from the group consisting of a refractory metal, W, Ti, Ta, and Mb. Thereby, the emission angle confinement means is resistant with respect to the conditions provided in and at the particle beam device, for instance thermally resistant, wear resistant and corrosion resistant.

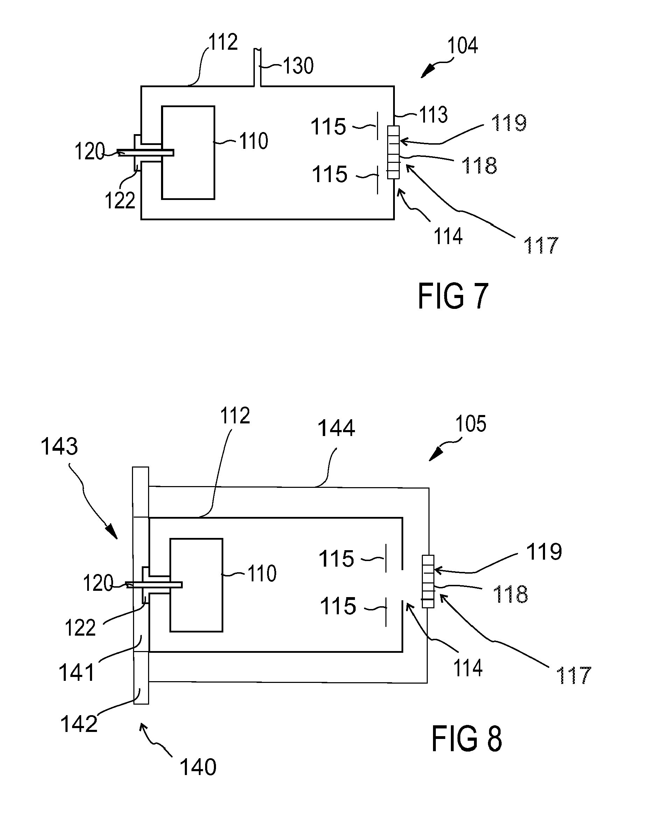

According to embodiments of the particle device, the impurity removing device may be provided in the opening or inside or outside of the housing. As examples of such embodiments, ion sources 102, 103, 104, 105 are illustrated in Figs. 5 to 8. For instance, as illustrated in Fig. 7, the impurity removing device 117 may be positioned in opening 114 of the ion source 104. In some examples, the extraction electrode 115 is provided inside of the housing 112, the impurity removing device 117 being positioned between the extraction electrode 115 and the opening 114, as shown in Fig. 5. In other examples, e.g. as illustrated in Figs. 6 and 8, the extraction electrode 115 is provided inside of the housing 112, the opening 114 being positioned between the extraction electrode 115 and the impurity removing device 117.

In some embodiments, the impurity removing device may be provided outside of the housing, the particle beam device further including an installation platform adapted to install the particle beam device at a substrate processing installation, the installation platform having a first part and a second part, the housing being provided at the first part and the impurity removing device being provided at the second part, wherein the first part and/or the second part are removable from the installation platform.

As an example of such an embodiment, ion source 105 is schematically shown in Fig. 8. Ion source 105 includes a platform 140 for installation at a substrate processing chamber. The platform 140 may be a vacuum flange and includes a first part 141 and a second part 142. Second part 142 includes an opening 143 for receiving and encompassing the first part 141. Second part 142 further includes a support 144 at which the impurity removing device 117 is installed. At the first part 141 the housing 112 including components corresponding to the ion source 100 is provided. The gas conduit (not shown in Fig. 8) for gas supply into the housing 112 may be provided at the first part 141 of the platform. The first part 141 may be removed from the second part 142 of the platform 140, while the second part 142 including the impurity removing device 117 remains mounted at the substrate processing chamber. In some embodiments, the second part 142 may also be removable from platform 140 and/or the substrate processing chamber, with and without the first part 141 being mounted in the second part 142. According to ion source 105, the impurity removing device 117 is positioned outside of the housing 112 between opening 114 and a substrate (not shown) to be processed. Thereby, impurities may be removed from the particle beam, such as particles other than the desired particles of the particle beam.

In further embodiments, which may be combined with any other embodiment described herein, the impurity removing device is at grounded or floating potential. Thereby, the impurities can safely be removed from the particle beam, e.g. by adsorption, while the particles of the particle beam intended to be used for substrate processing pass the impurity removing device and may, in addition, be aligned with the desired beam direction, e.g. by deflection at surfaces of the impurity removing device.

According to some embodiments, the emission angle confinement means may include a plurality of stripes each being made of a shapeable solid material and having a length and a width, the stripes being shaped to form, when adjoined to each other, an assembly including a plurality of three dimensional apertures having an length corresponding to the width of the stripes, and the stripes may be fixed in a frame. In some examples the stripes may have a thickness of 0.05 mm to 0.3 mm.

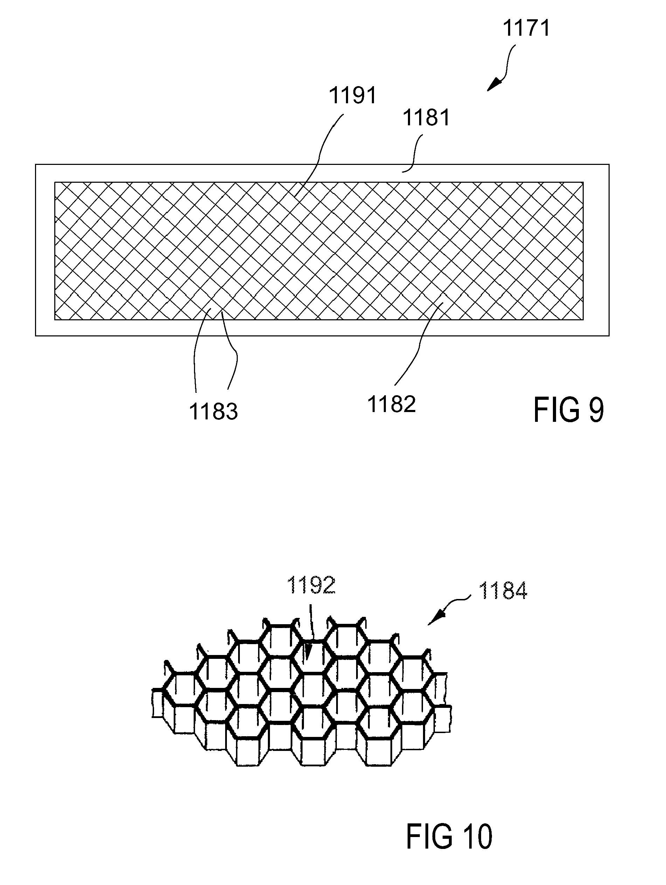

Fig. 9 shows as a typical example of embodiments an impurity removing device 1171 including a frame 1181 in which an emission angle confinement means 1182 is mounted. The emission angle confinement means 1182 is formed of a plurality of stripes 1183 having a zig-zag-pattern and being adjoined to each other such that they form a grating including apertures 1191 with a square cross section. In one embodiment, the width of each stripe may be in a range of typically about 9 to 13 mm, more typically about 10 to 12 mm. The length of the stripes may for example be in a range of about 40 mm to about 50 cm. The stripes may be formed of a material including at least one element selected from the group consisting of a refractory metal, W, Ti, Ta, and Mb. The frame 1181 may be of the same material as the stripes 1183 or of a different material, such as stainless steel. For mounting the impurity removing device 1171, the frame 1181 may be attached to, e.g., the front portion 113 of ion source 100.

In another embodiment, the plurality of stripes may be shaped such that they form, when adjoined to each other, an emission angle confinement means 1184 having a honeycomb structure including apertures 1192, as indicated in Fig. 10. In one embodiment, the emission angle confinement means may have a collimator structure.

According to one embodiment, a method of manufacturing a particle beam impurity removing device is provided, including a step of including into the particle beam impurity removing device at least one element selected from the group consisting of an emission angle confinement means adapted to confine the emission angles of a particle beam, an emission angle confinement means adapted to be provided within the particle beam and an emission angle confinement means adapted to be provided throughout a cross section of the particle beam.

According to a further embodiment, a method of manufacturing a particle beam impurity removing device having an emission angle confinement means adapted to confine the emission angles of a particle beam is provided, for instance a method for producing an impurity removing device as shown in Figs. 9 and 10. The method of manufacturing a particle beam impurity removing device includes a first step of providing a plurality of stripes each being made of a shapeable solid material and having a length and a width. In a second step, a stripe shaping device with two gear wheels is provided, one gear wheel being formed to engage the other gear wheel, the gear wheels being positioned engaging each other. Then in a third step, one stripe one after the other are passed lengthwise between the gear wheels and thereby shaped. After that, the shaped stripes are adjoined, thereby forming an emission angle confinement means assembly including a plurality of three dimensional apertures having an length corresponding to the width of the stripes. At least, the adjoined stripes are fixed in a frame.

In one example of above method, in the second step, a plurality of the stripes 1183 having a zig-zag-pattern may be formed. Consequently, the method of this example may result in emission angle confinement means 1182 mounted in frame 1181 and shown in Fig. 9. According to an alternative embodiment of above method, in the second step, a plurality of stripes having a shape including a row of indentations corresponding to the half of a hexagon may be formed. Hence, in the third step of adjoining the stripes, emission angle confinement means 1184 with a honeycomb structure as indicated in Fig. 10 is formed. The method allows for a reduction of waste material when producing the emission angle confinement means.

According to an alternative method of manufacturing a particle beam impurity removing device of embodiments described herein, a drilling of bore holes into a sheet, e.g. a metal sheet formed of the above mentioned materials, may be contemplated, resulting for instance in tubular apertures of the emission angle confinement means.

An operation of the particle beam device of embodiments is described referring to ion source 102 shown in Fig. 5. A gas which is to be ionized, in order to produce desired ions, is introduced into housing 112 through gas conduit 130. Electrons are generated by cathode 110 and accelerated inside of the housing 112, e.g. towards an electrode (not shown) under the influence of an electric field. The desired plasma is produced by interactions of the electrons with the gas molecules contained in the housing 112. Ions are extracted from the ion source 102 by extraction electrode 115 adjacent to the opening 114 such that they can exit through impurity removing device 117 and opening 114. Impurities generated due to interactions of the plasma or ions contained therein with inside components of the ion source 102, e.g. due to sputtering of the cathode 110, may also be directed to opening 114. A substantial amount of such impurities have trajectories not parallel to the beam direction 200, since the impurities mainly result from collisions of plasma particles with inside components or walls of the ion source 102 and/or deflection events of the impurities. Moreover, such impurities tend to have a velocity smaller than the ions of the plasma accelerated by extraction electrode 115. However, the emission angle confinement means 118 included in impurity removing device 117, which has for example tubular apertures in parallel to the ion beam direction, confines the emission angle of ions and impurities included in the ion beam in two dimensions as compared to, for instance, a slit opening not being provided with impurity removing device 117. Therefore, a substantial amount of the impurities is removed from the ion beam, e.g. adsorbed, by emission angle confinement means 118. The ions which are desired for substrate processing operations, however, pass emission angle confinement means 118, since they are extracted and accelerated by extraction electrode 115 along optical axis 200, i.e. substantially in parallel to the ion beam direction. In addition, the ions, which are desired for substrate processing, may even be aligned in parallel to the ion beam direction by emission angle confinement means 118, e.g. by deflection. The ion yield of ion source 102 and the ion energy of the resulting ion beam are not affected by embodiments described herein.

Hence, using the devices of embodiments described herein for processing of substrates, a contamination of the substrates and a reduced performance of products incorporating the substrates is avoided or even prevented by removing impurities from a particle beam. Moreover, the particles of the particle beam, which are intended to be used for substrate processing, may be aligned with the desired beam direction by the impurity removing device. In addition, the ratio of active emission region and wasted emission region of the particle beam can be optimized as compared to a particle beam produced by a particle beam device not being provided with an impurity removing device of embodiments described herein.

In one embodiment, a particle beam impurity removing device for removing impurities from a particle beam emitted in a beam direction is provided, including an emission angle confinement means adapted to confine emission angles of particles included in the particle beam.

In one embodiment, which can be combined with any other embodiment described herein, the emission angle confinement means is adapted to be provided within the particle beam.

In one embodiment, which can be combined with any other embodiment described herein, the emission angle confinement means is adapted to be provided throughout a cross section of the particle beam.

In one embodiment, which can be combined with any other embodiment described herein, the emission angle confinement means includes a plurality of three dimensional apertures having a length in a direction parallel to an emission angle of particles included in the particle beam

In one embodiment, which can be combined with any other embodiment described herein, each of the plurality of three dimensional apertures has a width perpendicular to the length, the length to width ratio being in a range of 1 to 5.

In one embodiment, which can be combined with any other embodiment described herein, the emission angle confinement means includes a plurality of three dimensional apertures having a length in a direction parallel to the beam direction of the particle beam.

In one embodiment, which can be combined with any other embodiment described herein, the emission angle confinement means includes at least one element selected from the group consisting of tubular apertures, tubular apertures having a circular cross section, tubular apertures having a polygonal cross section, apertures arranged in a pattern, apertures arranged in a regular pattern, and a honeycomb structure.

In one embodiment, which can be combined with any other embodiment described herein, the emission angle confinement means is formed of a material including at least one element selected from the group consisting of a refractory metal, W, Ti, Ta, and Mb.

In one embodiment, which can be combined with any other embodiment described herein, the emission angle confinement means includes a plurality of stripes each being made of a shapeable solid material and having a length and a width, the stripes being shaped to form, when adjoined to each other, an assembly including a plurality of three dimensional apertures having an length corresponding to the width of the stripes, and the stripes being fixed in a frame, and/or the stripes having a thickness of 0.05 mm to 0.3 mm.

In one embodiment, a particle beam device is provided, including a housing, a particle beam source included in the housing, an opening in the housing for emission of a particle beam from the housing in a beam direction, and a particle beam impurity removing device including an emission angle confinement means adapted to confine emission angles of particles included in the particle beam and being provided adjacent to the opening.

In one embodiment, which can be combined with any other embodiment described herein, during operation of the particle beam device, the emission angle confinement means is provided within the particle beam.

In one embodiment, which can be combined with any other embodiment described herein, during operation of the particle beam device, the emission angle confinement means is provided throughout a cross section of the particle beam.

In one embodiment, which can be combined with any other embodiment described herein, the impurity removing device is provided in a position selected from the group consisting of: in the opening, inside of the housing or outside of the housing.

In one embodiment, which can be combined with any other embodiment described herein, the impurity removing device is provided outside of the housing, the particle beam device further including an installation platform adapted to install the particle beam device at a substrate processing installation, the installation platform having a first part and a second part, the housing being provided at the first part and the impurity removing device being provided at the second part, wherein the first part and/or the second part are removable from the installation platform. The first part of the platform may encompass the second part of the platform.

In one embodiment, which can be combined with any other embodiment described herein, an extraction electrode is provided inside of the housing, the impurity removing device being positioned between the extraction electrode and the opening.

In one embodiment, which can be combined with any other embodiment described herein, an extraction electrode is provided inside of the housing, the opening being positioned between the extraction electrode and the impurity removing device.

In one embodiment, which can be combined with any other embodiment described herein, the particle beam device is at least one element selected from the group consisting of a charged particle beam device, an ion source and an electron source.

In one embodiment, which can be combined with any other embodiment described herein, the emission angle confinement means includes a plurality of stripes each being made of a shapeable solid material and having a length and a width, the stripes being shaped to form, when adjoined to each other, an assembly including a plurality of three dimensional apertures having an length corresponding to the width of the stripes, and the stripes being fixed in a frame, and/or the stripes having a thickness of 0.05 mm to 0.3 mm.

In one embodiment, a substrate processing installation is provided, including a particle beam device, the particle beam device including a housing, a particle beam source included in the housing, an opening in the housing for emission of a particle beam from the housing in a beam direction, and a particle beam impurity removing device including an emission angle confinement means adapted to confine emission angles of particles included in the particle beam and being provided adjacent to the opening.

In one embodiment, which can be combined with any other embodiment described herein, the impurity removing device is at grounded or floating potential.

According to a further embodiment, a method of manufacturing a particle beam impurity removing device is provided, including a step of including into the particle beam impurity removing device at least one element selected from the group consisting of an emission angle confinement means adapted to confine the emission angles of a particle beam, an emission angle confinement means adapted to be provided within the particle beam and an emission angle confinement means adapted to be provided throughout a cross section of the particle beam.

One embodiment, which can be combined with any other embodiment described herein, is directed to a method of manufacturing a particle beam impurity removing device having an emission angle confinement means adapted to confine the emission angles of a particle beam, the method including providing a plurality of stripes each being made of a shapeable solid material and having a length and a width, providing a stripe shaping device with two gear wheels, one gear wheel being formed to engage the other gear wheel, the gear wheels being positioned engaging each other, lengthwise passing one stripe one after the other between the gear wheels and thereby shaping the stripes, adjoining the shaped stripes and thereby forming an emission angle confinement means assembly including a plurality of three dimensional apertures having an length corresponding to the width of the stripes, and fixing the adjoined stripes in a frame.

The written description uses examples to disclose the invention, including the best mode, and also to enable any person skilled in the art to make and use the invention. While the invention has been described in terms of various specific embodiments, those skilled in the art will recognize that the invention can be practiced with modifications within the spirit and scope of the claims. Especially, mutually non-exclusive features of the examples of embodiments and embodiments or modifications thereof described above may be combined with each other. The patentable scope of the invention is defined by the claims, and may include other examples that occur to those skilled in the art. Such other examples are intended to be within the scope of the claims.

While the foregoing is directed to embodiments of the invention, other and further embodiments of the invention may be devised without departing from the basic scope thereof, and the scope thereof is determined by the claims that follow.

## Claims

1. A particle beam impurity removing device for removing impurities from a particle beam emitted in a beam direction, comprising an emission angle confinement means (118; 1182) adapted to confine emission angles of particles included in the particle beam.

2. The device of claim 1, wherein the emission angle confinement means is adapted to be provided within the particle beam and/or throughout a cross section of the particle beam.

3. A particle beam device, comprising
a housing (112),
a particle beam source (110, 115) included in the housing,
an opening (114) in the housing for emission of a particle beam from the housing in a beam direction (200), and
a particle beam impurity removing device (118; 1182) according to any of claims 1 and 2 and being provided adjacent to the opening (114).

4. The device of any of the preceding claims,
wherein the emission angle confinement means (118; 1182) includes a plurality of three dimensional apertures (119; 1191; 1192) having a length in a direction parallel to an emission angle of particles included in the particle beam or having a length in a direction parallel to the beam direction (200) of the particle beam.

5. The device of claim 4,
wherein each of the plurality of three dimensional apertures has a width perpendicular to the length, the length to width ratio being in a range of 1 to 5.

6. The device of any of the preceding claims,
wherein the emission angle confinement means includes at least one element selected from the group consisting of tubular apertures, tubular apertures having a circular cross section, tubular apertures having a polygonal cross section, apertures arranged in a pattern, apertures arranged in a regular pattern, a honeycomb structure, and a material including at least one element selected from the group consisting of a refractory metal, W, Ti, Ta, and Mb.

7. The particle beam device of any of claims 3 to 6,
wherein the impurity removing device is provided in the opening (114) or inside or outside of the housing (112).

8. The particle beam device of claim 7,
wherein the impurity removing device (118; 1182) is provided outside of the housing, the particle beam device further comprising an installation platform (140) adapted to install the particle beam device at a substrate processing installation,
the installation platform having a first part (141) and a second part (142), the housing being provided at the first part and
the impurity removing device being provided at the second part, wherein the first part and/or the second part are removable from the installation platform.

9. The particle beam device of any of claims 3 to 8,
wherein an extraction electrode (115) is provided inside of the housing, the impurity removing device being positioned between the extraction electrode and the opening.

10. The particle beam device of any of claims 3 to 9,
wherein an extraction electrode (115) is provided inside of the housing, the opening being positioned between the extraction electrode and the impurity removing device.

11. The particle beam device of any of claims 3 to 10,
wherein the particle beam device is at least one element selected from the group consisting of a charged particle beam device, an ion source and an electron source.

12. The device of any of the preceding claims,
wherein the emission angle confinement means includes a plurality of stripes (1183) each being made of a shapeable solid material and having a length and a width, the stripes being shaped to form, when adjoined to each other, an assembly including a plurality of three dimensional apertures having an length corresponding to the width of the stripes, and the stripes being fixed in a frame, and/or the stripes having a thickness of 0.05 mm to 0.3 mm.

13. A substrate processing installation comprising a particle beam device according to any of claims 3 to 12.

14. The substrate processing installation of claim 13,
wherein the impurity removing device is at grounded or floating potential.

15. Method of manufacturing a particle beam impurity removing device, comprising a step of including into the particle beam impurity removing device at least one element selected from the group consisting of an emission angle confinement means (118; 1182) adapted to confine the emission angles of a particle beam, an emission angle confinement means adapted to be provided within the particle beam and an emission angle confinement means adapted to be provided throughout a cross section of the particle beam.

16. The method of claim 15, comprising
providing a plurality of stripes (1183) each being made of a shapeable solid material and having a length and a width,
providing a stripe shaping device with two gear wheels, one gear wheel being formed to engage the other gear wheel, the gear wheels being positioned engaging each other,
lengthwise passing one stripe one after the other between the gear wheels and thereby shaping the stripes,
adjoining the shaped stripes and thereby forming an emission angle confinement means assembly including a plurality of three dimensional apertures having an length corresponding to the width of the stripes, and fixing the adjoined stripes in a frame.
